# EUROPEAN PATENT APPLICATION

(11) **EP 0 634 784 A1**
(43) Date of publication of application: **18.01.1995**
(21) Application number: 94304859.5
(22) Date of filing: 01.07.1994
(51) Int. Cl.: H01L 21/00

(54) **Variable speed wafer exchange robot**

(30) Priority: 16.07.1993 US 92677
(71) Applicant: APPLIED MATERIALS, INC., Santa Clara California 95054-3299 (US)
(72) Inventor: Tepman, Avi, Cupertino, CA 95014 (US)
(74) Representative: Bayliss, Geoffrey Cyril

(57) **Abstract**

The disclosure relates to a variable speed robot (80) located adjacent to a plurality of stations (26 to 32), including a wafer support assembly (84) capable of holding a wafer (36) and adapted to move between the staions sometimes holding a wafer and sometimes not holding a wafer. The wafer support is connected to a driver (102,104) which rotates the support about a rotational axis and causes the support to reciprocate between a retracted position and an extended position. The robot also includes a controller (78) that operates the driver at a first speed when the wafer support assembly holds a wafer and at a second speed when the wafer support assembly is not holding a wafer.

## Description

This invention relates generally to wafer exchange robots utilized in integrated vacuum process chambers and, more particularly, to a variable speed wafer exchange robot that moves at a slower speed when its wafer support carries a wafer and moves at a faster speed when the support is empty.

Integrated circuit processing technology is continuously concerned with reducing the size of circuits both to increase the amount of circuitry that can be packed into an integrated circuit of a given size and to increase the speed of operation by reducing the distance that signals need to travel within a circuit. Particulates of a diameter even several times smaller than the size of a circuit component can cause failure of the integrated circuit if a particulate is present at a critical location on the circuit. This problem is especially acute for large-area integrated circuits such as microprocessors and four-megabyte or larger memories because such circuits have an increased area over which a critical defect can occur.

The multi-layer structure of typical integrated circuits also increases the effect of particulates because a particulate incorporated into one level of a circuit can affect not only the circuitry on that level, but also circuitry on other levels. A defect in an embedded level of an integrated circuit can propagate through overlying layers, distorting the topography and thus disrupting operation of those circuit elements. For these reasons, it is important to minimize the amount of particulates that come into contact with a wafer immediately before and during processing. Accordingly, integrated vacuum process systems are used to limit particulate contamination.

Integrated vacuum process systems generally include a central vacuum load lock chamber having a storage elevator for holding wafers and at least one and preferably a multiplicity of vacuum processing chambers mounted to its exterior. The storage elevator and the processing chambers communicate with the load lock chamber via closable entrance slits between the load lock chamber and the storage elevator and the processing chambers. Each of the processing chambers can be adapted to perform one or more processes including gas chemistry etching, gas chemistry deposition, physical sputtering and rapid thermal annealing of one or more wafers positioned within the chamber.

Wafers are transferred from the storage elevator to the load lock chamber and then to the processing chamber by a wafer exchange robot that is mounted within the load lock chamber. Typically, wafers are positioned on a wafer support assembly that includes a blade located at its remote end, which can rotate about a rotational axis to move the blade between processing chambers (a Θ movement), and reciprocate (an R or radial movement) by moving the blade between an extended position in which the arm extends through a processing chamber's entrance slit and a retracted position in which the arm and blade are located only within the load lock chamber.

Previous wafer handling robots have included a horizontal wafer support controlled by dual motors to selectively position the wafer support at the openings of processing chambers and storage elevators and to extend and retract the support. Such robots are shown in U.S. Patent No. 4,951,601, and EP-A-0 423 608. While these provide a simple robotic load-lock wafer exchange system, in moving wafers within the integrated vacuum of the system, the speed of the wafer support structure is limited by the low friction coefficient between the wafer and the wafer support assembly in a vacuum. If the speed and especially the acceleration and deceleration exceed fairly low values, the coefficient of friction between the wafer support and the wave is insufficient to hold the wafer on the wafer support and it may slide and fall off the wafer support, an obviously unsatisfactory occurrence. Therefore, the speed and acceleration of the wafer support are held to fairly low values, which however increase the time required to process a wafer because of the slow speed at which the wafer support assembly travels.

One possible solution is the use of an elastomer friction pad with a high coefficient of friction to better hold the wafer on the blade. However, this solution is impractical because the temperatures used within the processing chambers will melt a pad made of most such material. While an electrostatic chuck is sometimes used to hold wafers, most chucks are too thick to be used when the spacing between a wafer cassette and a wafer is small. Moreover, the electric wires utilized by an electrostatic chuck can be difficult to maneuver.

Accordingly, there is a need to increase the speed of the wafer transfer system and therefore increase the output of the system without causing the wafer to slip off the blade. The present invention fulfills these needs.

Briefly, and in general terms, the present invention resides in a variable speed wafer exchange robot that operates at one speed when the robot's wafer support assembly carries a wafer and a second, faster, speed when the wafer support assembly is empty. More specifically, the acceleration of the robot on starting and stopping when holding a wafer are held below values at which the coefficient of friction between the wafer and the wafer support is insufficient to hold the wafer on the support.

In more specific terms, the present invention relates to a variable speed and variable acceleration robot located adjacent to one or more stations. The robot includes a wafer support assembly adapted to hold a wafer and to move between stations while sometimes holding a wafer and sometimes not holding a wafer. Preferably, the wafer support assembly is also rotates about a rotational axis and reciprocates between a retracted position and an extended position. A controller controls a driver which rotates and reciprocates the wafer support assembly. The controller operates the driver at a first speed or acceleration when the wafer support assembly is holding a wafer and at a second, higher speed or acceleration when the wafer support assembly is not holding a wafer.

In one preferred hardware embodiment, an R-Θ wafer-handling robot is mounted within a load lock chamber. The robot includes a horizontal wafer support assembly mounted on concentric drive shafts by a four-bar link mechanism. One variable-speed motor rotates the outer drive shaft and the wafer support assembly about an axis of rotation via the four-bar link mechanism to selectively position the wafer support at processing chambers and storage elevators. When the wafer support assembly is transporting a wafer between chambers, this motor operates at a relatively slow speed to prevent the wafer from sliding off the support. However, when the support is empty, this motor operates at a faster speed to more quickly position the wafer support at the next chamber.

A second variable-speed motor rotates the inner drive shaft and the wafer support via the four-bar link mechanism. This movement reciprocates the wafer support and extends and retracts it, so that it can be moved in and out of storage elevators and processing chambers. The speed at which this motor operates also increases when the wafer support is empty and decreases when it carries a wafer. In this embodiment, each motor is inoperative while the other motor is rotating.

In another hardware embodiment, two motors rotate simultaneously, either to rotate the wafer support between chambers or to extend or retract the wafer support into and out of an elevator or a processing chamber. When the wafer support is rotating, the motors rotate in the same direction, either clockwise or counterclockwise. However, when the wafer support is being extended or retracted, the motors rotate in opposite directions.

In this embodiment, each motor is magnetically connected through a motor chamber wall to a coupling inside a load-lock chamber. Four extensions or struts are pivotally connected between the couplings and the wafer support assembly to form a "frog leg" type connection. The frog legs extend or retract when the motors rotate in different directions, and the wafer support assembly pivots when the motors rotate in the same direction. With either movement, the motors operate at a faster speed when the wafer support is empty and a slower speed when it carries a wafer.

Other features and advantages of the present invention will become apparent from the following description of the preferred embodiment, taken in conjunction with the accompanying drawings, which illustrate, by way of example, the principles of the invention.
Figure 1 is a simplified top plan view, partly schematic, of a multiple chamber integrated process system, illustrated without the load lock chamber and process chamber covers;
Figure 2 is a vertical cross-section view, partly schematic, of the process system of Figure 1;
Figure 3 is an enlarged, partial top plan view of the wafer support assembly of Figure 1;
Figure 4 is a vertical cross-section view of a magnetic coupling utilized in a second embodiment of the present invention to magnetically couple rotational motion from two motors to a wafer support assembly; and
Figure 5 is a plan view of a converter for converting rotational movement of a pair of motors into the separate rotation of a wafer support blade about a central axis and linear, radial extension and retraction of the blade.

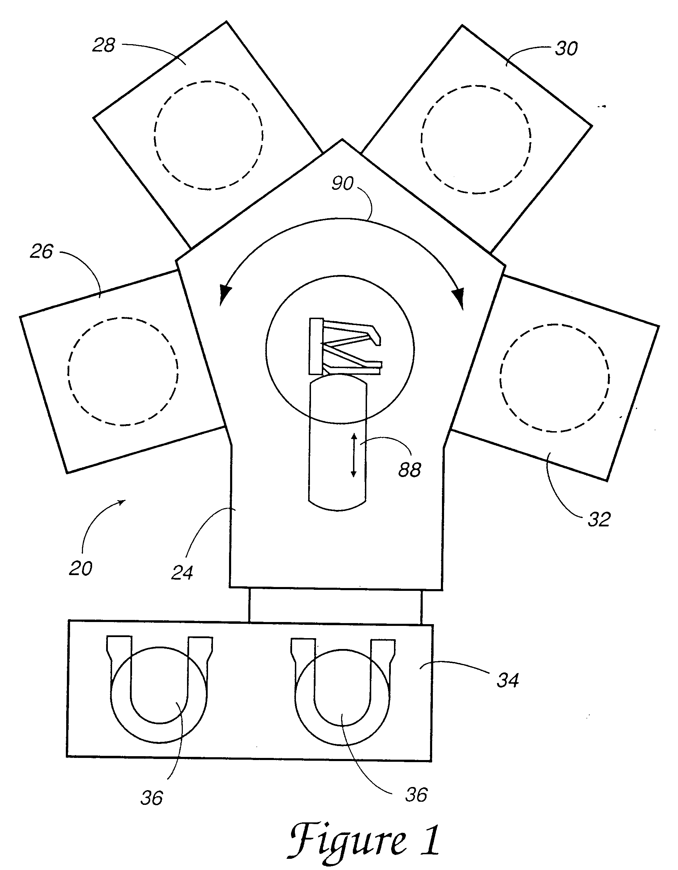

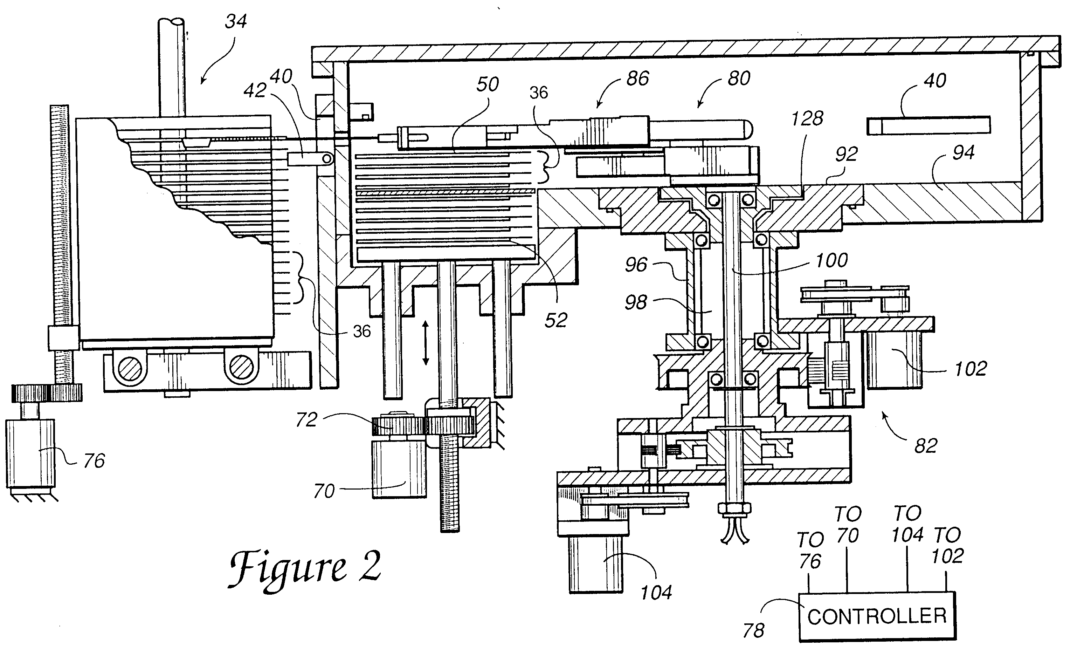

Referring now to the drawings, and particularly to Figures 1 and 2 thereof, there is shown a multiple-chamber integrated process system 20 including an enclosed, generally pentagonal main frame or housing 22 having five sidewalls that define an enclosed vacuum load lock chamber 24.

A number of individual vacuum processing chambers, illustratively chambers 26, 28, 30 and 32, are mounted one each on an associated sidewall of the load lock chamber 24. An external cassette elevator 34 is adapted for vertically stacking a multiplicity of cassettes which in turn hold wafers 36 horizontally. The external cassette elevator assembly 34 selectively positions each cassette directly opposite and aligned with a load lock chamber entrance slit or opening 40.

The vacuum processing chambers 26, 28, 30 and 32 and the associated main frame walls also have communicating slits which are similar or identical to the load lock entrance slit 40. Doors or slit valves 42 are provided for sealing these access slits 40. The load lock chamber 24 has an internal storage elevator assembly 50 that holds a number of wafers 36, illustratively up to eight, on horizontal support plates 52. The elevator 50 indexes the wafers vertically to present the wafers in a horizontal position for loading and unloading to and from the central robot.

Typically, the internal storage elevator cassette assembly 50 can be raised and lowered by a gear set 72 driven by a motor 70 that is controlled by a conventional controller, a small, general-purpose computer or personal computer 78. A robotic wafer transfer system 80 is mounted within the load lock chamber 24 for transferring the wafers 36 between the external elevator 34 and the internal elevator 50, between the internal elevator 50 and the individual processing chambers 26, 28, 30 and 32, and between the processing chambers. Both elevators 34 and 50 and the procssing chambers 26 through 32 are stations serviced by the robot 80.

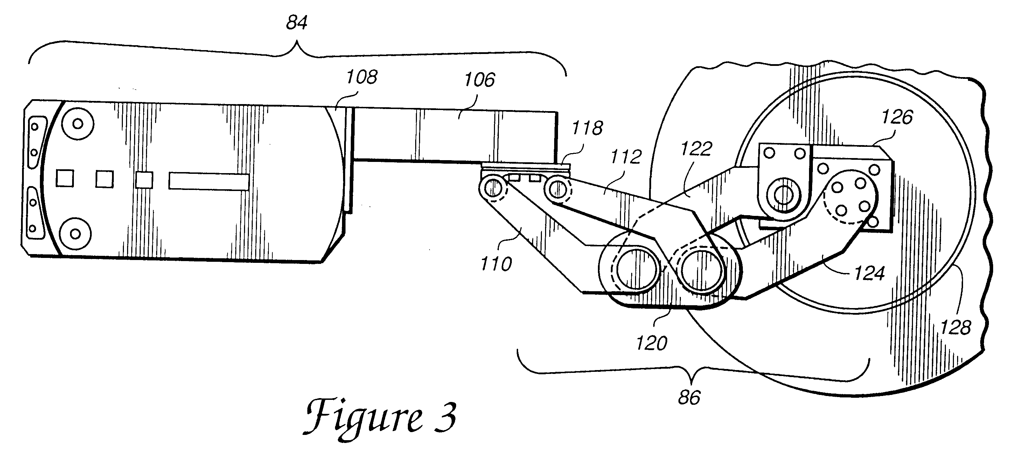

The robot 80 includes a driver in the form of a concentric-shaft, rotational-drive system 82 that imparts reversible R-Θ (reciprocating and rotational) movement to a wafer support assembly 84 (Figure 3) via a four-bar link mechanism 86 for effecting the desired cassette-to-elevator, elevator-to-chamber and chamber-to-chamber wafer transfer. The R or reciprocating movement (straight line extension and retraction) is indicated by arrow 88 in Figure 1, while the pivotal Θ or rotational movement is along arrow 90. Importantly for the invention, the robot sometimes holds a wafer while moving from one point to another and at other times does not hold a wafer while moving. For instance, the robot 80 may move empty to the elevator 50 to pick up a wafer, move full from the elevator to a processing chamber 26, 28, 30 or 32, and withdraw empty from the chamber to allow the wafer to be processed within the chamber.

Referring further to Figure 2, the robot assembly 80 includes a removable base plate 92 mounted to the bottom wall 94 of the load-lock chamber 24. A hollow outer shaft 96 is fixed to the base plate, and a hollow middle shaft 98 rotates within the outer shaft via journal bearings. An inner shaft 100 is mounted by journal bearings within the middle shaft 98. The concentric middle shaft 98 and inner shaft 100 are independently rotated, typically by stepper motors 102 and 104, through cable and drum drive mechanisms. In turn, the operation of respective stepper motors 102 and 104 is controlled by the controller/computer 78. Rotation of the inner shaft 100 and the rotation of the outer shaft 96 are converted into precise R and Θ movement, respectively, of the wafer support assembly 84 by the four-bar link mechanism 86. The speed of the rotation of the stepper motors 102 and 104 is also controlled by the computer 78 which provides pulses to the stepper motors at a faster rate when the wafer support assembly is empty, and at a slower rate when the wafer support assembly is carrying a wafer.

Referring to Figure 3, the wafer support assembly 84 includes arm 106 and a replaceable metal blade 108, on which is formed a guard rail 109 having two curved segments with a diameter slightly larger than that of the wafer. Although the guard rail 109 usually prevents the wafer from falling off the blade 108, even the contact of the wafer with the guard rail 109 will generate undesirable particles. Hence, even sliding of the wafer on the blade is not desirable.

The wafer support assembly also includes the four-bar link mechanism 86 having first and second arms 110 and 112 that are pivotally mounted at spaced points along a connecting link 118 fixedly mounted to arm 106. The opposite ends of the arms are mounted at spaced points along a second connecting link 120. The four-bar link mechanism 86 further includes third and fourth arms 122 and 124 that are pivotally mounted to the link 120 along with first and second arms 110 and 112. The third arm 122 is mounted at its opposite end to a bracket 126 via a pivot pin. The bracket itself is fixedly mounted to a disk or collar 128 which is mounted to the top of the middle shaft 98. The fourth arm 124 is fixedly mounted to the top of the inner shaft 100, which extends through the collar 128.

Because of this cooperative mounting to common link 120, the reversible rotation of the inner shaft 100 rotates the fourth arm 124 and thereby transforms the shaft rotation into bidirectional translation of link 118 and wafer support assembly 84. As a consequence of the fixed relative positions of the pivot points linking the arms on link 120, of the pivot point on bracket 126, and of the pivot points on link 118, the four-bar link mechanism 86 maintains its parallelogram-like configuration during rotation. The movement of the four-bar link mechanism 86 during rotation of the inner shaft 100 and the middle shaft 98 is more fully described in U.S. Patent No. 4,951,601.

The R-Θ movement of the robot 80 inserts the blade 108 through the entrance slit 40 into a selected process chamber over the wafer support susceptor or electrode within that chamber. Within the chamber, a wafer-lifting mechanism, such as fingers or a ring, lifts the wafer from the blade and transfers the wafer to the associated chamber electrode or susceptor for processing. Because the controller 78 controls both the robot 80 and the wafer-lifting mechanism, it now recognizes that the blade 108 is empty, and it therefore provides pulses to the motors 102 and 104, controlling the middle shaft 98 and the inner shaft 100, at the faster speed in the reverse. This may be done because there is no danger that a wafer will slide off the blade, yet it allows the blade to move more quickly to its next destination. When the wafer is removed from the chamber, the empty blade travels into the chamber at the higher speed, and the full blade exits the chamber at the lower speed.

Although the centrifugal force potentially causing the wafer to slide on the blade 108 is proportional to the speed of the rotating blade 108 during its Θ movement, the corresponding inertial force during both the R and Θ movement of the blade 108 is proportional to the blade's acceleration. Accordingly, both the speed and acceleration may need to be limited when the blade 108 is bearing a wafer, and there may be a set of limiting speeds and accelerations for the complex movement of the robot 80 and its blade 108 while bearing a wafer and another set while not bearing a wafer. That is, different limiting speeds and accelerations may apply during radial and circumferential (R and Θ) movements dependent on the geometry and the coefficient of friction between the wafer and its support.

In the preferred embodiment, the blade travels at a radial speed of about 8 inches (20.3 cm) per second and accelerates at a rate of 4 inches (10.2 cm) per second squared when carrying a wafer. These values correspond to 60,000 steps/s and 30,000 steps/s² being produced by the stepper motors. In the preferred embodiment, the blade travels at a tangential speed and acceleration equal at the radius of rotation of the wafer to the radial speed and acceleration. At the rotation radius, the centrifugal force is less important compared to the inertial force. Of course, the stated speed is attained only after the initial acceleration period and before the terminal deceleration period. Also the acceleration value refers to both the acceleration and deceleration. These relatively slow speed and acceleration are mandated by the low frictional coefficient between the blade and the wafer in the vacuum environment of the load lock chamber and the processing chambers. However, when the blade is empty, in the preferred embodiment, the controller 78 controls the motors to rotate more quickly to move the blade at a faster speed of about 32 inches (81.3 cm) per second and a faster acceleration of 16 inches (40.6 cm) per second squared. Of course, this increased speed allows the blade to reach its destination much faster and decreases the wafer processing time correspondingly. Of course, the invention is not limited to these sets of speed and acceleration, the speed and acceleration may vary non-proportionally, and in some situations only one or the other of the speed and acceleration may need to vary.

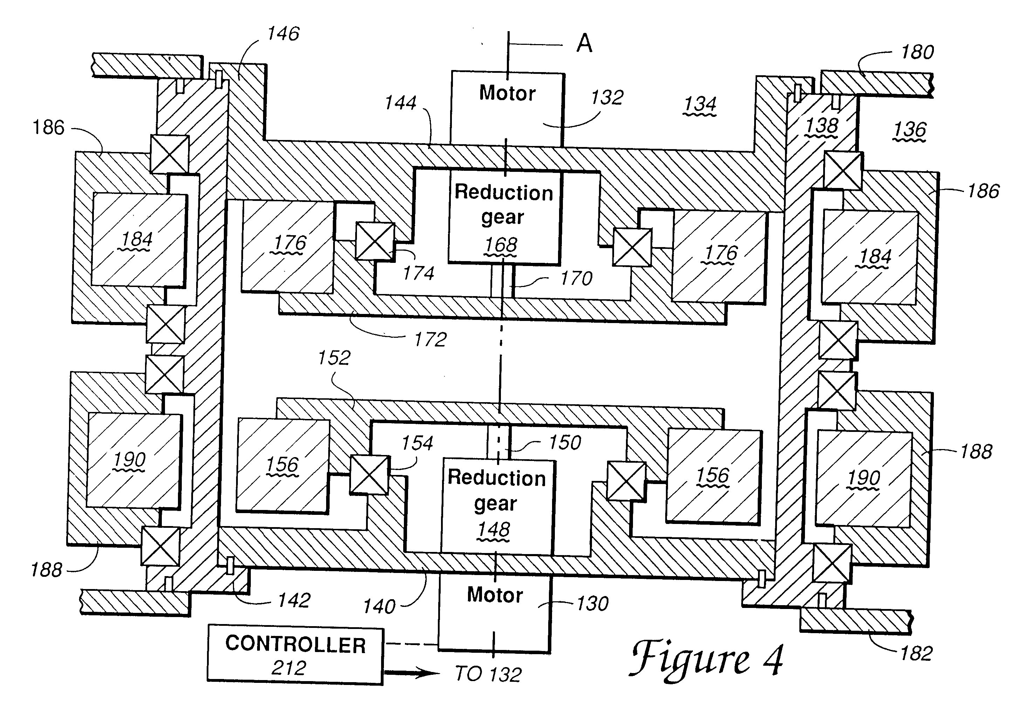

The variable speed operation of the motor or motors controlling the movements of the wafer support assembly can be incorporated into any robotic system. A second embodiment is shown in Figure 4 where the driver to rotate and to reciprocate the wafer support assembly consists of motors 130 and 132 that are housed within a cylindrical motor chamber 134. A second, robot chamber 136 radially encircles the motor chamber and houses the robot.

In this embodiment, as with the embodiment described above, motors 130 and 132 are electric motors, but in alternative embodiments, these motors can be replaced by pneumatic motors, gas-powered motors or any other actuator that can provide rotational power. A sidewall 138 defines the radial extent of the motor chamber 134 and enables a pressure difference to exist between the motor chamber and the robot chamber 136.

The lower motor 130 is bolted to a motor mount 140 that rests on a shoulder 142 of the sidewall 138. Alignment pins extend from the motor mount into the shoulder to prevent rotation of the mount relative to the sidewall. Similarly, the upper motor 132 is bolted to a motor mount 144 that has a shoulder 146 that rests on top of the sidewall 138. Additional alignment pins prevent rotation of the upper mount relative to the sidewall.

The lower motor 130 is coupled to a reduction gear 148 to reduce the rotation speed of a typical motor to a rotation of a gear output shaft 150 more appropriate to providing power to the robot. The reduction gear output shaft is attached to a lower motor magnet clamp 152 that presses against a bearing 154 and holds a set of lower motor magnets 156, each of which is closely spaced from the sidewall 138. Similarly, the upper motor 132 is coupled to a reduction gear 168 and a gear output shaft 170 that is attached to an upper motor magnet clamp 172 that presses against a bearing 174 and holds a set of upper motor magnets 176.

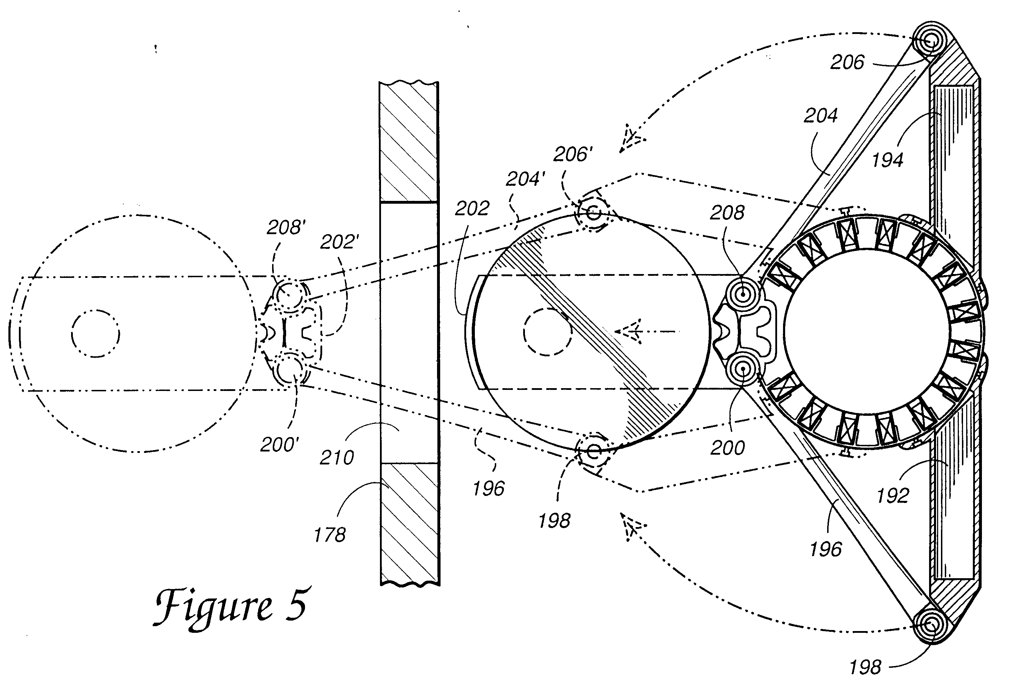

The robot vacuum chamber 136 is enclosed by cylindrical inner sidewall 138, an outer wall 178 (shown in Figure 5), a top wall 180 and bottom wall 182 that are bolted to one another. Within the robot chamber is a set of upper robot magnets 184 retained by an upper robot magnet clamp 186 that is similar to the motor magnet clamps 152 and 172. A similar lower robot magnet clamp 188 holds a set of lower robot magnets 190. A set of bearings enable the robot magnet clamps to rotate about a motor axis A.

Figure 5 is a top view of a robot incorporating the second embodiment. In this embodiment, the extension for converting rotations of the driver into rotation of the wafer support assembly about a rotational axis and a reciprocating movement between a retracted position and an extended position consists of a four strut assembly. A first strut 192 is rigidly attached to the upper robot magnet clamp 186 and a second strut 194 is rigidly attached to the lower robot magnet clamp 188. A third strut 196 is attached by a pivot 198 to the first strut and by a pivot 200 to a wafer blade 202. A fourth strut 204 is attached by a pivot 206 to the second strut and by another pivot 208 to the wafer blade. This structure of struts and pivots forms a "frog leg" type connection of the wafer blade to the robot magnetic clamps 186 and 188.

When the lower motor 130 and the upper motor 132, and therefore the lower robot magnet clamp 188 and the upper robot magnet clamp 186, rotate in the same direction, then the wafer blade 202 also rotates in this direction to position the wafer blade in front of a processing chamber or storage elevator. When the motors and corresponding robot magnet clamps rotate in opposite directions, then there is no rotation of the wafer blade. Instead, as shown in Figure 5, there is a linear radial movement of the wafer blade to a position illustrated by dashed elements 192 through 208. The linear radial movement can be used to extend and retract the wafer blade through a processing chamber entrance slot 210.

The speed, direction and amount of rotation of both the lower motor 130 and the upper motor 132 is controlled by a controller or computer 212 (Figure 4). The controller determines where the wafer blade 202 must be positioned perform the next wafer exchange with the next processing chamber or storage elevator (Figure 1) in the manufacturing process. The controller then rotates both motors, and thereby the robot magnet clamps 186 and 188, the appropriate distance and in the correct and same direction. To exchange a wafer, the controller rotates the motors in opposite directions, as described above.

As with the first embodiment described, the controller 212 controls all of the components of the robot. Accordingly, the controller recognizes the times during the manufacturing process when the wafer blade is empty without the necessity of sensors. At that point in the process, the controller increases the rate at which it sends pulses to the motors so that the wafer support assembly will reach its destination faster and will enter or exit a processing chamber faster. Whether the motors are rotating in the same direction to rotate an empty wafer blade or in opposite directions to extend or retract an empty wafer blade, the faster rotation of the motors decreases the time the wafer blade is travelling between processing chambers or storage elevators, and correspondingly decreases manufacturing time.

It will be appreciated from the foregoing description that the present invention provides an improved robot for the transportation of wafers and other types of substrates between processing chambers or storage stations. The increased speed or acceleration of the robot in both R and Θ movements when the wafer support blade is empty decreases manufacturing time without sacrificing wafer transfer control. Although the present invention has been described in detail with reference only to the presently preferred embodiments, those of ordinary skill will appreciate that various modifications can be made without departing from the invention. Accordingly, the invention is limited only by the following claims.

## Claims

1. A variable speed robot located adjacent to a plurality of stations, comprising:
a wafer support assembly adapted to hold a wafer, adapted to move between stations sometimes holding a wafer and sometimes not holding a wafer, adapted to move in a first direction and to move in a second direction;
a driver connected to the wafer support assembly to rotate and to reciprocate the wafer support assembly; and
a controller to control the driver at a first set of speed and acceleration when the wafer support assembly holds a wafer and at a second set of speed and acceleration when the wafer support assembly is not holding a wafer.

2. A robot as claimed in claim 1, characterised in that the speed in the second set is faster than the speed in the first set.

3. A robot as claimed in claim 2, characterised in that the speed in the first set is about 8 inches per second and the speed in the second set is about 32 inches per second.

4. A robot as claimed in any one of claims 1 to 3, characterised in that the acceleration in the second set is faster than the acceleration in the first set.

5. A robot as claimed in claim 4, characterised in that the acceleration in the first set is about 4 inches per second squared and the acceleration in the second set is about 16 inches per second squared.

6. A robot as claimed in any of the preceding claims, characterised in that the wafer support assembly includes:
a wafer support blade; and
at least one extension for converting rotations of the driver into rotation of the wafer support assembly about a rotational axis and a reciprocating movement between a retracted position and an extended position.

7. A robot as claimed in any of the preceding claims, characterised in that the driver includes:
a first motor;
a first coupling for coupling rotational movement from the first motor to the wafer support assembly;
a second motor; and
a second coupling for coupling rotational movement from the second motor to the wafer support assembly.

8. A robot as claimed in claim 7, characterised in that both said first and second motors are stepper motors.

9. A substrate transfer mechanism, comprising:
a movable substrate support for selectively holding a wafer on a surface thereof;
a driver selectively moving said substrate support in a plurality of directions; and
a controller controlling said driver to move said substrate support at a first set of one or more speeds and accelerations while said substrate support holds a substrate and at a second set of one or more speeds and accelerations while said substrate support does not hold a substrate.

10. A substrate transfer mechanism as claimed in claim 9, wherein said first set of speeds and accelerations produce a smaller force on a substrate held by substrate support than said second set of speeds and accelerations.

11. A substrate transfer mechanism as claimed in claim 9 or claim 10, characterised in that only said one or more speeds vary between said first and second sets.

12. A substrate transfer mechanism as claimed in any of claims 9 to 11, characterised in that only said one or more accelerations vary between said first and second sets.

13. A substrate transfer mechanism as claimed in claim 9 or claim 10, characterised in that both of said one or more speeds and of said one or more accelerations vary between first and second sets.

14. A method for moving a robot adapted to hold a substrate while moving between a plurality of stations, comprising:
a first step of moving the robot at a first speed and with a first acceleration when the robot is holding a substrate; and
a second step of moving the robot at a second speed and with a second acceleration when the robot is not holding a substrate;
wherein at least one of said first speed and first acceleration substantially differs from a corresponding one of said second speed and second acceleration.

15. A method as claimed in claim 15, characterised in that the second speed is faster than the first speed.

16. A method as claimed in claim 14, characterised in that the second acceleration is faster than the first acceleration.

17. A method as claimed in claim 17, characterised in that the second speed is faster than the first speed.

18. A method as claimed in claim 17, characterised in that the first speed is about 8 inches per second, the second speed is about 32 inches per second, the first acceleration is about 4 inches per second squared and said second acceleration is about 16 inches per second squared.

19. A method as claimed in any of claims 14 to 18, characterised in that both the first and second moving steps comprise rotating the robot about a rotational axis and moving the robot radially with respect to said rotational axis.
